(19)

Europäisches
Patentamt

European
Patent Office

Office européen
des brevets

(11) EP 4 579 340 A2

(12) **EUROPEAN PATENT APPLICATION**

(43) Date of publication:
02.07.2025 Bulletin 2025/27

(21) Application number: 25170109.0

(22) Date of filing: 11.04.2025

(51) International Patent Classification (IPC):
**G03F 7/00** (2006.01)

(52) Cooperative Patent Classification (CPC):
**G03F 7/706**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(71) Applicant: **ASML Netherlands B.V.**
**5500 AH Veldhoven (NL)**

(72) Inventors:
• **GUI, Li**
**5500 AH Veldhoven (NL)**
• **LEENDERS, Martinus, Hendrikus, Antonius**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD AND SYSTEM FOR DETERMINING OPTICAL ABERRATIONS AND LITHOGRAPHIC APPARATUS INCLUDING THE SYSTEM**

(57) The disclosure provides a method for determining aberrations of projection optics of a lithographic apparatus using multiple first gratings arranged on a reticle (MA) and corresponding multiple second gratings arranged at or near a substrate table (WT), the method comprising the steps of: projecting a beam (B) of radiation from a source (SO) towards the substrate table through an illumination slit (CS) and via projection optics of a projection system (PS); moving the first gratings (15) at a first speed relative to the illumination slit (CS); receiving light reflected from the first gratings by the second gratings (19) while moving the second gratings relative to the first gratings at a second speed, capturing radiation received through the second gratings to provide images, determining phase curves for each pixel of the respective images, and using the phase curves for determining aberrations of the projection optics.

Fig. 13

EP 4 579 340 A2

**Description**

<u>FIELD</u>

The present invention relates to a method and a system for determining optical aberrations. The system may be included in an exposure apparatus, such as a lithographic apparatus. The system may be intended for measuring aberrations in projection optics of the exposure apparatus.

<u>BACKGROUND</u>

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Radiation that has been patterned by the patterning device is focussed onto the substrate using a projection system. The projection system may introduce optical aberrations, which cause the image formed on the substrate to deviate from a desired image (for example a diffraction limited image of the patterning device).

It may be desirable to provide methods and apparatus for accurately determining such aberrations caused by a projection system such that these aberrations can be better controlled. For state of the art lithography, allowing the highest accuracy and smallest line width, aberration measurements of the projection optics may typically be done before every lot, or even before every exposure.

For instance, WO-2022/248154-A1 describes diffraction gratings for a phase-stepping measurement system for determining an aberration map for a projection system.

The measurement may include a phase stepping method, typically using an alignment sensor, such as an ILIAS or PARIS sensor. The measurement typically includes subsequent steps. Each step corresponds to a relative position of a first grating (at or near the mask, for instance at the reticle stage RS) and a second grating (typically at or near the substrate to be exposed, for instance at the substrate stage WS). Subsequent measurements are performed in sequence, including a relative movement of the first grating with respect to the second grating, to establish a phase curve. Optical aberrations are derived based on said phase curve.

The conventional method described above is relatively slow and cannot be accelerated due to the required movement of the gratings between subsequent measurements. The movement includes stepping of stages and requires time, for instance on the order of 10 ms.

The disadvantage referenced above may be exacerbated for certain grating layouts and/or shapes of the illuminating radiation. For instance, the 'first grating' and/or the 'second grating' may, in fact, comprise multiple gratings in parallel. For instance, both the reticle stage grating and the wafer stage grating may comprise an array of, for instance, two to ten gratings. Said array is, typically, arranged in a straight line due to substrate and reticle layouts and to maximize the area of the respective reticle and substrate available for output, i.e. to produce a product. In addition, for EUV based exposure apparatuses, the EUV radiation is typically projected onto the substrate in a curved shape, for instance by including a curved opening or slit in the optical path. As a consequence, typically not all gratings included in the linear array of gratings can be measured in a single measurement. Consequently, it takes even more time to complete the phase map for all gratings in the array, for instance requiring multiple measurements or multiple steps per measurement.

The present disclosure aims to provide an improved method and system for measuring aberrations in the projection optics of an exposure apparatus.

<u>SUMMARY</u>

The present disclosure provides a method and system in accordance with the appended claims.

The disclosure provides a method for determining aberrations of a projection system of a lithographic apparatus, the method comprising the steps of:

> providing multiple first gratings arranged on a reticle;
> providing multiple second gratings arranged at or near a substrate table,
> projecting a beam of radiation from a source towards the first gratings through an illumination slit and to the substrate table via projection optics of the projection system;

receiving reflected radiation from the first gratings by the second gratings while moving the second gratings relative to the reflected radiation of the first gratings;

capturing radiation received through the second gratings to provide images, and

using the images to determine aberrations of the projection optics.

In an embodiment, the method comprises the steps of determining phase curves for each pixel of the respective images, and using the phase curves for determining the aberrations of the projection optics.

In an embodiment, the step of capturing radiation received through the second gratings includes using a camera sensor in a high frequency flash mode.

In an embodiment, the first speed and the second speed are substantially constant.

In an embodiment, the first speed differs from the second speed.

In an embodiment, the step of capturing radiation includes capturing images covering at least two periods of a mismatch between the first gratings and the second gratings.

In an embodiment, the images are captured at a sample rate allowing at least two or more images per grating period of the second gratings.

In an embodiment, the illumination slit is curved, and wherein the multiple first gratings and the multiple second gratings are arranged linearly.

In an embodiment, the first speed and the second speed have a direction of movement which is substantially perpendicular to the linear arrangement of the first gratings and the second gratings.

According to another aspect, the disclosure provides a system for determining aberrations of projection optics of a lithographic apparatus, the system comprising:

multiple first gratings arranged on a reticle;

multiple second gratings arranged at or near a substrate table,

a source for projecting a beam of radiation towards the substrate table through an illumination slit and via projection optics of a projection system; and

a detector for capturing radiation received through the second gratings to provide images,

the detector being adapted to:

- receive reflected radiation from the first gratings and transmitted through the second gratings,
- make images while moving the second gratings relative to the first gratings, and
- use the images for determining aberrations of the projection optics. In an embodiment, the detector includes a camera sensor able to operate in a high frequency flash mode.

In an embodiment, the illumination slit is curved providing a curbed beam, and wherein the multiple first gratings and the multiple second gratings are arranged linearly.

In an embodiment, the system is adapted to move the reflection of the first gratings at a first speed and the second gratings at a second speed in a direction of movement which is substantially perpendicular to the linear arrangement of the first gratings and the second gratings. Herein, the first speed and the second speed are typically constant yet different, resulting in a constant relative speed of the second gratings with respect to the reflected radiation as reflected off the first gratings.

According to another aspect, the present disclosure provides a lithographic system comprising the system or method as described herein above.

In an embodiment, the lithographic system includes a source of EUV radiation for providing the beam of radiation.

BRIEF DESCRIPTION OF THE DRAWINGS

Embodiments of the invention will now be described, by way of example only, with reference to the accompanying schematic drawings, in which:

- Figure 1 depicts a lithographic system comprising a lithographic apparatus and a radiation source;
- Figure 2 is a schematic illustration of a measurement system suitable for a system according to the present disclosure;
- Figures 3A and 3B are schematic illustrations of a patterning device and a sensor apparatus which may form part of the measurement system of Figure 2;
- Figure 4 is a schematic illustration of a measurement system suitable for a system according to the present disclosure, the measurement system comprising a first patterned region and a second patterned region, the first patterned region arranged to receive radiation and to form a plurality of first diffraction beams;

- Figures 5A to 5C each shows a different set of second diffraction beams formed by the second patterned region of the measurement system shown in Figure 4, that set of second diffraction beams having been produced by a different first diffraction beam formed by the first patterned region;
- Figure 6 shows an example of multiple phase maps corresponding to multiple gratings obtained using curved illumination, for instance by illuminating via a curved opening;
- Figure 7 shows a schematic representation of subsequent steps of stepped aberration measurements;
- Figure 8 shows a schematic representation of stepping phase corresponding to the steps of Figure 7;
- Figure 9 shows a diagram exemplifying a phase curve on a sensor pixel, wherein the vertical axis represents intensity and the horizontal axis represents phase;
- Figure 10 shows an example of a phase gradient map obtained by fitting the samples as exemplified in Figure 9;
- Figure 11 shows an example of a grating array illuminated using a curved radiation beam;
- Figure 12 shows another example of a grating array illuminated using a curved radiation beam;
- Figure 13 shows an array of images of overlapping grating images illuminated using a curved beam of radiation, exemplifying a method of the present disclosure;
- Figure 14 shows a diagram exemplifying moves of respective grating arrays and sampling, wherein the vertical axis represents relative phase, the horizontal axis represents time, and the dotted lines exemplify sampling instances; and
- Figure 15 shows an exemplary diagram of samples obtained using a method of the disclosure and a phase curve fitted to said samples.

## DETAILED DESCRIPTION

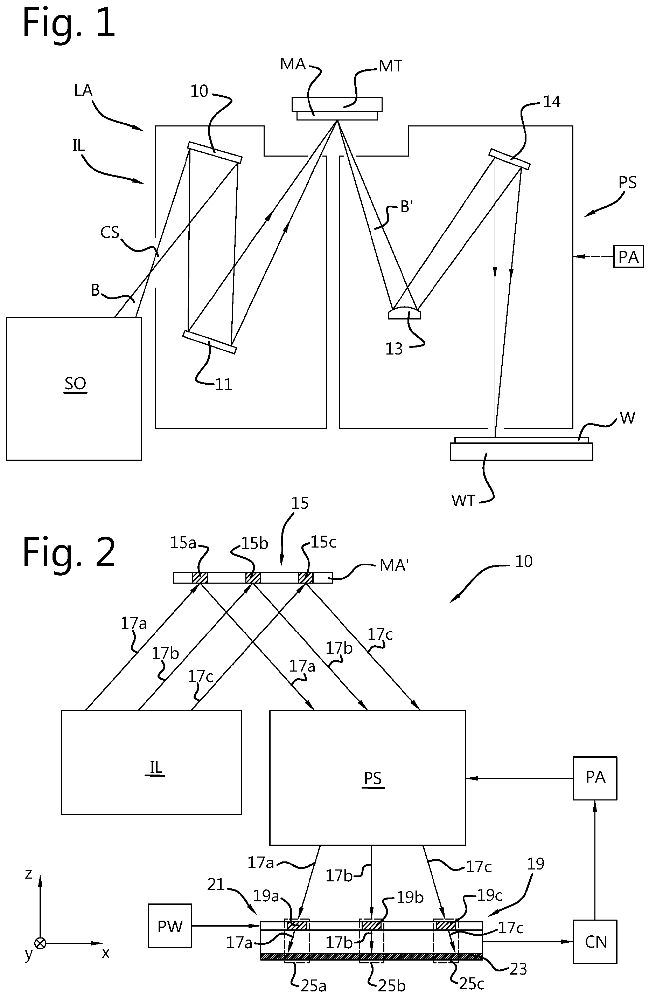

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction a patterned EUV radiation beam B' is generated. The projection system PS is configured to project the patterned EUV radiation beam B' onto the substrate W. For that purpose, the projection system PS may comprise a plurality of mirrors 13, 14 which are configured to project the patterned EUV radiation beam B' onto the substrate W held by the substrate table WT. The projection system PS may apply a reduction factor to the patterned EUV radiation beam B' thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

In general, the projection system PS has an optical transfer function which may be nonuniform, which can affect the pattern which is imaged on the substrate W. For unpolarized radiation such effects can be fairly well described by two scalar maps, which describe the transmission (apodization) and relative phase (aberration) of radiation exiting the projection system PS as a function of position in a pupil plane thereof. These scalar maps, which may be referred to as the transmission map and the relative phase map, may be expressed as a linear combination of a complete set of basis functions. A particularly convenient set is the Zernike polynomials, which form a set of orthogonal polynomials defined on a unit circle. A determination of each scalar map may involve determining the coefficients in such an expansion. Since the Zernike polynomials are orthogonal on the unit circle, the Zernike coefficients may be obtained from a measured scalar map by calculating the inner product of the measured scalar map with each Zernike polynomial in turn and dividing this by the square of the norm of that Zernike polynomial. In the following, unless stated otherwise, any reference to Zernike coefficients will be understood to mean the Zernike coefficients of a relative phase map (also referred to herein as an aberration map). It will be appreciated that in alternative embodiments other sets of basis functions may be used. For example some embodiments may use Tatian Zernike polynomials, for example for obscured aperture systems.

The wavefront aberration map represents the distortions of the wavefront of light approaching a point in an image plane of the projection system PS from a spherical wavefront (as a function of position in the pupil plane or, alternatively, the angle at which radiation approaches the image plane of the projection system PS). As discussed, this wavefront aberration map $W(x, y)$ may be expressed as a linear combination of Zernike polynomials:

$$(1)$$

$$W(x, y) = \sum_n c_n \cdot Z_n(x, y)$$

where $x$ and $y$ are coordinates in the pupil plane, $Z_n(x, y)$ is the nth Zernike polynomial and $c_n$ is a coefficient. It will be appreciated that in the following, Zernike polynomials and coefficients are labelled with an index which is commonly referred to as a Noll index. Therefore, $Z_n(x, y)$ is the Zernike polynomial having a Noll index of n and $c_n$ is a coefficient having a Noll index of n. The wavefront aberration map may then be characterized by the set of coefficients $c_n$ in such an expansion, which may be referred to as Zernike coefficients.

It will be appreciated that only a finite number of Zernike orders are taken into account. Different Zernike coefficients of the phase map may provide information about different forms of aberration which are caused by the projection system PS. The Zernike coefficient having a Noll index of 1 may be referred to as the first Zernike coefficient, the Zernike coefficient having a Noll index of 2 may be referred to as the second Zernike coefficient and so on.

The first Zernike coefficient relates to a mean value (which may be referred to as a piston) of a measured wavefront. The first Zernike coefficient may be irrelevant to the performance of the projection system PS and as such may not be determined using the methods described herein. The second Zernike coefficient relates to the tilt of a measured wavefront in the x-direction. The tilt of a wavefront in the x-direction is equivalent to a placement in the x-direction. The third Zernike coefficient relates to the tilt of a measured wavefront in the y-direction. The tilt of a wavefront in the y-direction is equivalent to a placement in the y-direction. The fourth Zernike coefficient relates to a defocus of a measured wavefront. The fourth Zernike coefficient is equivalent to a placement in the z-direction. Higher order Zernike coefficients relate to other forms of aberration which are caused by the projection system (e.g. astigmatism, coma, spherical aberrations and other effects).

Throughout this description the term "aberrations" should be intended to include all forms of deviation of a wavefront from a perfect spherical wavefront. That is, the term "aberrations" may relate to the placement of an image (e.g. the second, third and fourth Zernike coefficients) and/or to higher order aberrations such as those which relate to Zernike coefficients having a Noll index of 5 or more. Furthermore, any reference to an aberration map for a projection system may include all forms of deviation of a wavefront from a perfect spherical wavefront, including those due to image placement.

The transmission map and the relative phase map are field and system dependent. That is, in general, each projection system PS will have a different Zernike expansion for each field point (i.e. for each spatial location in its image plane).

As will be described in further detail below, the relative phase of the projection system PS in its pupil plane may be determined by projecting radiation from an object plane of the projection system PS (i.e. the plane of the patterning device MA), through the projection system PS and using a shearing interferometer to measure a wavefront (i.e. a locus of points with the same phase). The shearing interferometer may comprise a diffraction grating, for example a two dimensional diffraction grating, in an image plane of the projection system (i.e. the substrate table WT) and a detector arranged to detect an interference pattern in a plane that is conjugate to a pupil plane of the projection system PS.

The projection system PS comprises a plurality of optical elements (including mirrors 13, 14). As already explained, although the projection system PS is illustrated as having only two mirrors 13, 14 in Figure 1, the projection system PS may include a different number of mirrors (e.g. six or eight mirrors). The lithographic apparatus LA further comprises adjusting means PA for adjusting these optical elements so as to correct for aberrations (any type of phase variation across the pupil plane throughout the field). To achieve this, the adjusting means PA may be operable to manipulate optical elements within the projection system PS in one or more different ways. The projection system may have a co-ordinate system wherein its optical axis extends in the z direction (it will be appreciated that the direction of this z axis changes along the optical path through the projection system, for example at each mirror or optical element). The adjusting means PA may be operable to do any combination of the following: displace one or more optical elements; tilt one or more optical elements; and/or deform one or more optical elements. Displacement of optical elements may be in any direction (x, y, z or a combination thereof). Tilting of optical elements is typically out of a plane perpendicular to the optical axis, by rotating about axes in the x or y directions although a rotation about the z axis may be used for non-rotationally symmetric optical elements. Deformation of an optical element may be performed for example by using actuators to exert force on sides of the optical element and/or by using heating elements to heat selected regions of the optical element. In general, it may not be possible to adjust the projection system PS to correct for apodizations (transmission variation across the pupil plane). The transmission map of a projection system PS may be used when designing masks MAs for the lithographic apparatus LA.

The adjusting means PA may be operable to move the support structure MT and/or the substrate table WT. The adjusting means PA may be operable to displace (in any of the x, y, z directions or a combination thereof) and/or tilt (by rotating about axes in the x or y directions) the support structure MT and/or the substrate table WT.

The projection system PS which forms part of a lithographic apparatus may periodically undergo a calibration process. For example, when a lithographic apparatus is manufactured in a factory the optical elements (e.g. mirrors) which form the projection system PS may be set up by performing an initial calibration process. After installation of a lithographic apparatus at a site at which the lithographic apparatus is to be used, the projection system PS may once again be calibrated. Further calibrations of the projection system PS may be performed at regular intervals. For example, under normal use the projections system PS may be calibrated every few months (e.g. every three months).

Calibrating a projection system PS may comprise passing radiation through the projection system PS and measuring the resultant projected radiation. Measurements of the projected radiation may be used to determine aberrations in the projected radiation which are caused by the projection system PS. Aberrations which are caused by the projection system PS may be determined using a measurement system. In response to the determined aberrations, the optical elements which form the projection system PS may be adjusted so as to correct for the aberrations which are caused by the projection system PS.

Figure 2 is a schematic illustration of a measurement system 10 which may be used to determine aberrations which are caused by a projection system PS. The measurement system 10 comprises an illumination system IL, a measurement patterning device MA', a sensor apparatus 21 and a controller CN. The measurement system 10 may form part of a lithographic apparatus. For example, the illumination system IL and the projection system PS which are shown in Figure 2 may be the illumination system IL and projection system PS of the lithographic apparatus which is shown in Figure 1. For ease of illustration additional components of a lithographic apparatus are not shown in Figure 2.

The measurement patterning device MA' is arranged to receive radiation from the illumination system IL. The sensor apparatus 21 is arranged to receive radiation from the projection system PS. During normal use of a lithographic apparatus, the measurement patterning device MA' and the sensor apparatus 21 which are shown in Figure 2 may be located in positions that are different to the positions in which they are shown in Figure 2. For example, during normal use of a lithographic apparatus a patterning device MA which is configured to form a pattern to be transferred to a substrate W may be positioned to receive radiation from the illumination system IL and a substrate W may be positioned to receive radiation from the projection system PS (as is shown, for example, in Figure 1). The measurement patterning device MA' and the sensor apparatus 21 may be moved into the positions in which they are shown in Figure 2 in order to determine aberrations which are caused by the projection system PS. The measurement patterning device MA' may be supported by a support structure MT, such as the support structure which is shown in Figure 1. The sensor apparatus 21 may be supported by a substrate table, such as the substrate table WT which is shown in Figure 1. Alternatively the sensor apparatus 21 may be supported by a measurement table (not shown) which may be separate to the sensor table WT.

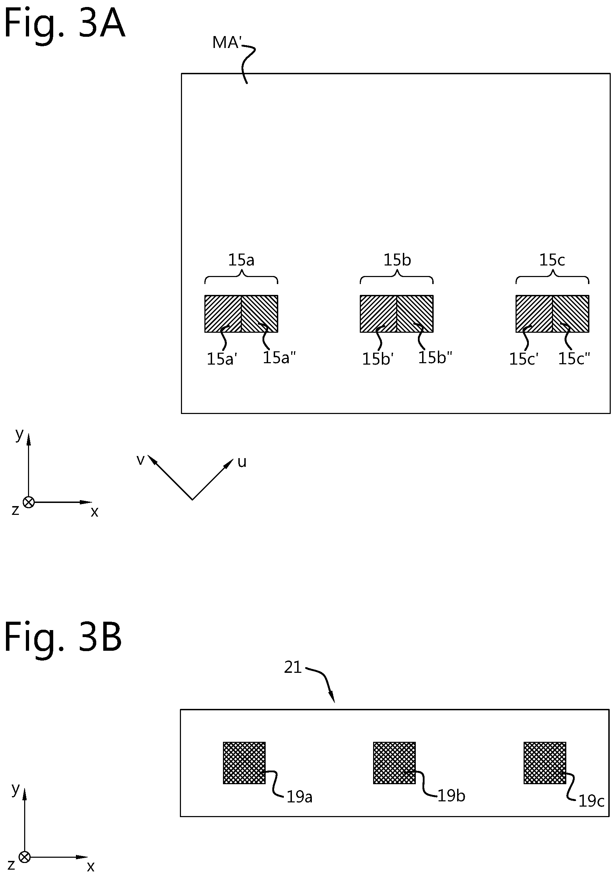

The measurement patterning device MA' and the sensor apparatus 21 are shown in more detail in Figures 3A and 3B. Cartesian co-ordinates are used consistently in Figures 2, 3A and 3B. Figure 3A is a schematic illustration of the measurement patterning device MA' in an x-y plane and Figure 3B is a schematic illustration of the sensor apparatus 21 in an x-y plane.

The measurement patterning device MA' comprises a plurality of patterned regions 15a-15c. In the embodiment which is shown in Figures 2 and 3A the measurement patterning device MA' is a reflective patterning device MA'. The patterned regions 15a-15c each comprise a reflective diffraction grating. Radiation which is incident on the patterned regions 15a-15c of the measurement patterning device MA' is at least partially scattered by thereby and received by the projection system PS. In contrast, radiation which is incident on the remainder of the measurement patterning device MA' is not reflected or scattered towards the projection system PS (for example, it may be absorbed by the measurement patterning device MA').

The illumination system IL illuminates the measurement patterning device MA' with radiation. Whilst not shown in Figure 2, the illumination system IL may receive radiation from a radiation source SO and condition the radiation so as to illuminate the measurement patterning device MA'. For example, the illumination system IL may condition the radiation so as to provide radiation having a desired spatial and angular distribution. In the embodiment which is shown in Figure 2, the illumination system IL is configured to form separate measurement beams 17a-17c. Each measurement beam 17a-17c illuminates a respective patterned region 15a-15c of the measurement patterning device MA'.

In order to perform a determination of aberrations which are caused by the projection system PL, a mode of the illumination system IL may be changed in order to illuminate the measurement patterning device MA' with separate measurement beams 17a-17c. For example, during normal operation of a lithographic apparatus, the illumination system IL may be configured to illuminate a patterning device MA with a slit of radiation. However the mode of the illumination system IL may be changed such that the illumination system IL is configured to form separate measurement beams 17a-17c in order to perform a determination of aberrations caused by the projection system PL. In some embodiments different patterned regions 15a-15c may be illuminated at different times. For example, a first subset of the patterned regions 15a-15c may be illuminated at a first time so as to form a first subset of measurement beams 17a-17c and a second subset of patterned regions 15a-15c may be illuminated at a second time so as to form a second subset of measurement beams 17a-17c.

In other embodiments the mode of the illumination system IL may be unchanged in order to perform a determination of aberrations caused by the projection system PL. For example, the illumination system IL may be configured to illuminate the measurement patterning device MA' with a slit of radiation (e.g. which substantially corresponds with an illumination area used during exposure of substrates). Separate measurement beams 17a-17c may then be formed by the measurement patterning device MA' since only the patterned regions 15a-15c reflect or scatter radiation towards the projection system PS.

In the Figures the Cartesian co-ordinate system is shown as being conserved through the projection system PS. However, in some embodiments the properties of the projection system PS may lead to a transformation of the co-ordinate system. For example, the projection system PS may form an image of the measurement patterning device MA' which is magnified, rotated and/or mirrored relative to the measurement patterning device MA'. In some embodiments the projection system PS may rotate an image of the measurement patterning device MA' by approximately 180° around the z-axis. In such an embodiment the relative positions of a first measurement beam 17a and a third measurement beam 17c which are shown in Figure 2, may be swapped. In other embodiments the image may be mirrored about an axis which may lie in an x-y plane. For example, the image may be mirrored about the x-axis or about the y-axis.

In embodiments in which the projection system PS rotates an image of the measurement patterning device MA' and/or the image is mirrored by the projection system PS, the projection system is considered to transform the co-ordinate system. That is, the co-ordinate system which is referred to herein is defined relative to an image which is projected by the projection system PS and any rotation and/or mirroring of the image causes a corresponding rotation and/or mirroring of the co-ordinate system. For ease of illustration, the co-ordinate system is shown in the Figures as being conserved by the projection system PS. However, in some embodiments the co-ordinate system may be transformed by the projection system PS.

The patterned regions 15a-15c modify the measurement beams 17a-17c. In particular, the patterned regions 15a-15c cause a spatial modulation of the measurement beams 17a-17c and cause diffraction in the measurement beams 17a-17c. In the embodiment which is shown in Figure 3B the patterned regions 15a-15c each comprise two distinct portions. For example, a first patterned region 15a comprises a first portion 15a' and a second portion 15a". The first portion 15a' comprises a diffraction grating which is aligned parallel to a u-direction and the second portion 15a" comprises a diffraction grating which is aligned parallel to a v-direction. The u and v-directions are depicted in Figure 3A. The u and v-directions are both aligned at approximately 45° relative to both the x and y-directions and are aligned perpendicular to each other. Second 15b and third 15c patterned regions which are shown in Figure 3A are identical to the first patterned region 15a and each comprise first and second portions whose diffraction gratings are aligned perpendicular to each other.

The first and second portions of the patterned regions 15a-15c may be illuminated with the measurement beams 17a-17c at different times. For example, the first portions of each of the patterned regions 15a-15c may be illuminated by the measurement beams 17a-17c at a first time. At a second time the second portions of each of the patterned regions 15a-15c may be illuminated by the measurement beams 17a-17c. As was mentioned above in some embodiments different patterned regions 15a-15c may be illuminated at different times. For example, the first portions of a first subset of patterned regions 15a-15c may be illuminated at a first time and the first portions of a second subset of patterned regions 15a-15c may be illuminated at a second time. Second portions of the first and second subsets of patterned regions may be illuminated at the same or different times. In general any schedule of illuminating different portions of patterned regions 15a-15c may be used.

The modified measurement beams 17a-17c are received by the projection system PS. The projection system PS forms an image of the patterned regions 15a-15c on the sensor apparatus 21. The sensor apparatus 21 comprises a plurality of diffraction gratings 19a-19c and a radiation detector 23. The diffraction gratings 19a-19c are arranged such that each diffraction grating 19a-19c receives a respective modified measurement beam 17a-17c which is output from the projection system PS. The modified measurement beams 17a-17c which are incident on the diffraction gratings 19a-19c are further modified by the diffraction gratings 19a-19c. The modified measurement beams which are transmitted at the diffraction gratings 19a-19c are incident on the radiation detector 23.

The radiation detector 23 is configured to detect the spatial intensity profile of radiation which is incident on the radiation detector 23. The radiation detector 23 may, for example, comprise an array of individual detector elements or sensing elements. For example, the radiation detector 23 may comprise an active pixel sensor such as, for example, a CMOS (complementary metal-oxide-semiconductor) sensor array. Alternatively, the radiation detector 23 may comprise a CCD (charge-coupled device) sensor array. The diffraction gratings 19a-19c and portions of the radiation sensor 23 at which the modified measurement beams 17a-17c are received form detector regions 25a-25c. For example, a first diffraction grating 19a and a first portion of the radiation sensor 23 at which a first measurement beam 17a is received together form a first detector region 25a. A measurement of a given measurement beam 17a-17c may be made at a respective detector region 25a-25c (as depicted). As was described above, in some embodiments the relative positioning of the modified measurement beams 17a-17c and the co-ordinate system may be transformed by the projection system PS.

The modification of the measurement beams 17a-17c which occurs at the patterned regions 15a-15c and the diffraction gratings 19a-19c of the detector regions 25a-25c results in interference patterns being formed on the radiation detector 23. The interference patterns are related to the derivative of the phase of the measurement beams and depend on aberrations caused by the projection system PS. The interference patterns may therefore be used to determine aberrations which are caused by the projection system PS.

In general, the diffraction gratings 19a-19c of each of the detector regions 25a-25c comprises a two-dimensional transmissive diffraction grating. In the embodiment which is shown in Figure 3B the detector regions 25a-25c each comprise a diffraction grating 19a-19c which is configured in the form of a checkerboard. As described further below, embodiments of the present invention have particular application to arrangements where the detector regions 25a-25c each comprises a two-dimensional transmissive diffraction grating 19a-19c that is not configured in the form of a checkerboard.

Illumination of the first portions of the patterned regions 15a-15c may provide information related to aberrations in a first direction and illumination of the second portions of the patterned regions 15a-15c may provide information related to aberrations in a second direction.

In some embodiments, the measurement patterning device MA' and/or the sensor apparatus 21 is sequentially scanned and/or stepped in two perpendicular directions. For example, the measurement patterning device MA' and/or the sensor apparatus 21 may be stepped relative to each other in the u and v-directions. The measurement patterning device MA' and/or the sensor apparatus 21 may be stepped in the u-direction whilst the second portions 15a"-15c" of the patterned regions 15a-15c are illuminated and the measurement patterning device MA' and/or the sensor apparatus 21 may be stepped in the v-direction whilst the first portions 15a'-15c' of the patterned regions 15a-15c are illuminated. That is, the measurement patterning device MA' and/or the sensor apparatus 21 may be stepped in a direction which is perpendicular to the alignment of a diffraction grating which is being illuminated.

The measurement patterning device MA' and/or the sensor apparatus 21 may be stepped by distances which correspond with a fraction of the grating period of the diffraction gratings. Measurements which are made at different stepping positions may be analysed in order to derive information about a wavefront in the stepping direction. For example, the phase of the first harmonic of the measured signal (which may be referred to as a phase stepping signal) may contain information about the derivative of a wavefront in the stepping direction. Stepping the measurement patterning device MA' and/or the sensor apparatus 21 in both the u and v-directions (which are perpendicular to each other) therefore allows information about a wavefront to be derived in two perpendicular directions (in particular, it provides information about a derivative of the wavefront in each of the two perpendicular directions), thereby allowing the full wavefront to be reconstructed.

In addition to stepping of the measurement patterning device MA' and/or the sensor apparatus 21 in a direction which is perpendicular to the alignment of a diffraction grating which is being illuminated (as was described above), the measurement patterning device MA' and/or the sensor apparatus 21 may also be scanned relative to each other. Scanning of the measurement patterning device MA' and/or the sensor apparatus 21 may be performed in a direction which is parallel to the alignment of a diffraction grating which is being illuminated. For example, the measurement patterning device MA' and/or the sensor apparatus 21 may be scanned in the u-direction whilst the first portions 15a'-15c' of the patterned regions 15a-15c are illuminated and the measurement patterning device MA' and/or the sensor apparatus 21 may be scanned in the v-direction whilst the second portions 15a"-15c" of the patterned regions 15a-15c are illuminated. Scanning of the measurement patterning device MA' and/or the sensor apparatus 21 in a direction which is parallel to the alignment of a diffraction grating which is being illuminated allows measurements to be averaged out across the diffraction grating, thereby accounting for any variations in the diffraction grating in the scanning direction. Scanning of the measurement patterning device MA' and/or the sensor apparatus 21 may be performed at a different time to the stepping of the measurement patterning device MA' and/or the sensor apparatus 21 which was described above.

It will be appreciated that a variety of different arrangements of the patterned regions 15a-15c and the detector regions 25a-25c may be used in order to determine aberrations caused by the projection system PS. The patterned regions 15a-15c and/or the detector regions 25a-25c may comprise diffraction gratings. In some embodiments the patterned regions 15a-15c and/or the detector regions 25a-25c may comprise components other than a diffraction grating. For example, in some embodiments the patterned regions 15a-15c and/or the detector regions may comprise a single slit or a pin-hole opening through which at least a portion of a measurement beam 17a-17c may propagate. In general the patterned regions and/or the detector regions may comprise any arrangement which serves to modify the measurement beams.

The controller CN receives measurements made at the sensor apparatus 21 and determines, from the measurements, aberrations which are caused by the projection system PS. The controller may be configured to control one or more components of the measurement system 10. For example, the controller CN may control a positioning apparatus PW which is operable to move the sensor apparatus 21 and/or the measurement patterning device MA' relative to each other. The controller may control an adjusting means PA for adjusting components of the projection system PS. For example, the adjusting means PA may adjust optical elements of the projection system PS so as to correct for aberrations which are caused by the projection system PS and which are determined by the controller CN.

In some embodiments, the controller CN may be operable to control the adjusting means PA for adjusting the support structure MT and/or the substrate table WT. For example, the adjusting means PA may adjust support structure MT and/or substrate table WT so as to correct for aberrations which are caused by placement errors of patterning device MA and/or substrate W (and which are determined by the controller CN).

Determining aberrations (which may be caused by the projection system PS or by placement errors of the patterning device MA or the substrate W) may comprise fitting the measurements which are made by the sensor apparatus 21 to Zernike polynomials in order to obtain Zernike coefficients. Different Zernike coefficients may provide information about different forms of aberration which are caused by the projection system PS. Zernike coefficients may be determined independently at different positions in the x and/or the y-directions. For example, in the embodiment which is shown in Figure 2, 3A and 3B, Zernike coefficients may be determined for each measurement beam 17a-17c.

In some embodiments the measurement patterning device MA' may comprise more than three patterned regions, the sensor apparatus 21 may comprise more than three detector regions and more than three measurement beams may be formed. This may allow the Zernike coefficients to be determined at more positions. In some embodiments the patterned regions and the detector regions may be distributed at different positions in both the x and y-directions. This may allow the Zernike coefficients to be determined at positions which are separated in both the x and the y-directions.

Whilst, in the embodiment which is shown in Figures 2, 3A and 3B the measurement patterning device MA' comprises three patterned regions 15a-15c and the sensor apparatus 21 comprises three detector regions 25a-25c, in other embodiments the measurement patterning device MA' may comprise more or less than three patterned regions 15a-15c and/or the sensor apparatus 21 may comprise more or less than three detector regions 25a-25c.

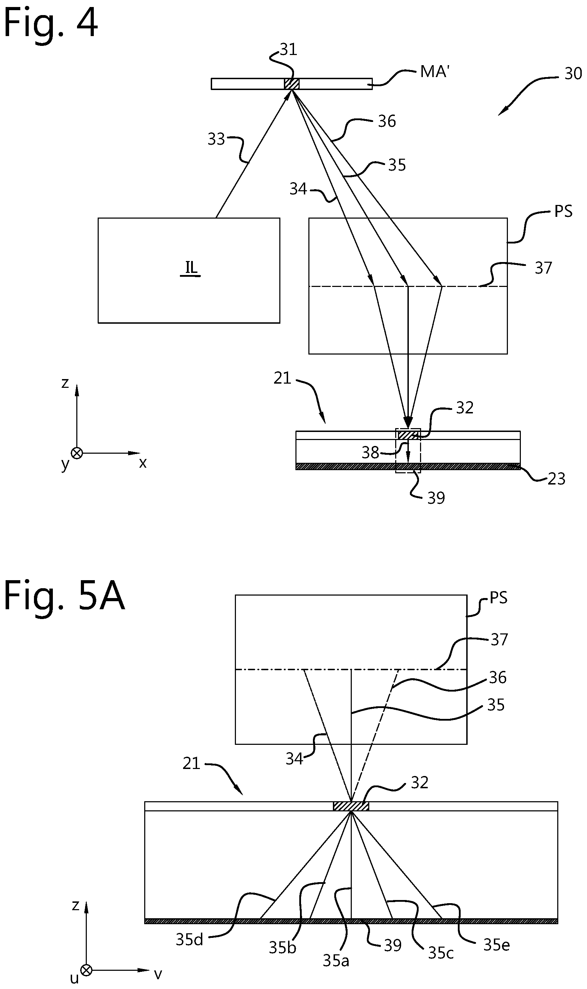

Methods for determining aberrations caused by a projection system PS are now described with reference to Figure 4.

In general, measurement patterning device MA' comprises at least one first patterned region 15a-15c and the sensor apparatus 21 comprises at least one second patterned region 19a-19c.

Figure 4 is a schematic illustration of a measurement system 30 which may be used to determine aberrations which are caused by a projection system PS. Measurement system 30 may be the same as the measurement system 10 shown in Figure 2, however, it may have a different number of first patterned regions (on measurement patterning device MA') and second patterned regions (in the sensor apparatus 21). Therefore, the measurement system 30 shown in Figure 4 may include any features of the measurement system 10 shown in Figure 2 described above and these features will not be further described below.

In Figure 4, only a single first patterned region 31 is provided on the measurement patterning device MA' and a single second patterned region 32 is provided in the sensor apparatus 21.

The measurement patterning device MA' is irradiated with radiation 33 from the illumination system IL. For ease of understanding only a single line (which may, for example, represent a single ray, for example the chief ray, of an incident radiation beam) is shown in Figure 4. However, it will be appreciated that the radiation 33 will comprise a range of angles incident on the first patterned region 31 of the measurement patterning device MA'. That is, each point on the first patterned region 31 of the measurement patterning device MA' may be illuminated by a cone of light. In general, each point is illuminated by substantially the same range of angles, this being characterized by the intensity of radiation in a pupil plane of the illumination system IL (not shown).

The first patterned region 31 is arranged to receive the radiation 33 and to form a plurality of first diffraction beams 34, 35, 36. A central first diffraction beam 35 corresponds to a $0^{th}$ order diffraction beam of first patterned region 31 and the other two first diffraction beams 34, 36 correspond to the $\pm 1^{st}$ order diffraction beams of first patterned region 31. It will be appreciated that more, higher order diffraction beams will, in general, also be present. Again for ease of understanding, only three first diffraction beams 34, 35, 36 are shown in Figure 4.

It will also be appreciated that, as the incoming radiation 33 comprises a cone of radiation converging on a point on the first patterned region 31, each of the first diffraction beams 34, 35, 36 also comprises a cone of radiation diverging from that point on the first patterned region 31.

To achieve the generation of the first diffraction beams 34, 35, 36, the first patterned region 31 may be of the form of a diffraction grating. For example, the first patterned region 31 may be generally of the form of the patterned region 15a shown in Figure 3A. In particular, at least a portion of the first patterned region 31 may be of the form of the first portion 15a' of the patterned region 15a shown in Figure 3A, i.e. a diffraction grating which is aligned parallel to a u-direction (note that Figure 4 is shown in the z-v plane). Therefore, the first diffraction beams 34-36 are separated in a shearing direction, which is the v-direction.

The first diffraction beams 34-36 are at least partially captured by the projection system PS, as now described. How much of the first diffraction beams 34-36 is captured by the projection system PS will be dependent on: the pupil fill of the incident radiation 33 from the illumination system IL; the angular separation of the first diffraction beams 34-36 (which in turn is dependent on the pitch of the first patterned region 31 and the wavelength of the radiation 33); and the numerical aperture of the projection system PS.

The measurement system 30 may be arranged such that first diffraction beam 35 that corresponds to the $0^{th}$ order diffraction beam substantially fills the numerical aperture of the projection system PS, which may be represented by a circular region of a pupil plane 37 of the projection system PS, and the first diffraction beams 34, 36 that correspond to the $\pm 1^{st}$ order diffraction beams overlap significantly with the first diffraction beam 35 that corresponds to the $0^{th}$ order diffraction beam. With such an arrangement, substantially all of the first diffraction beam 35 that corresponds to the $0^{th}$ order diffraction beam and most of the first diffraction beams 34, 36 that correspond to the $\pm 1^{st}$ order diffraction beams is captured by the projection system PS and projected onto the sensor apparatus 21. (Furthermore, with such an arrangement a large number of diffraction beams generated by the first patterned region 31 are at least partially projected onto the sensor apparatus 21).

The role of the first patterned region 31 is to introduce spatial coherence, as now discussed.

In general, two rays of radiation 33 from the illumination system IL that are incident on the same point of the measurement patterning device MA' at different angles of incidence are not coherent. By receiving the radiation 33 and forming a plurality of first diffraction beams 34, 35, 36, the first patterned region 31 may be considered to form a plurality of copies of the incident radiation cone 33 (the copies having, in general different phases and intensities). Within any one of these copies, or first diffraction beams 34, 35, 36, two rays of radiation which originate from the same point on the measurement patterning device MA' but at different scattering angles, are not coherent (due to the properties of the illumination system IL). However, for a given ray of radiation within any one of the first diffraction beams 34, 35, 36 there is a corresponding ray of radiation in each of the other first diffraction beams 34, 35, 36 that is spatially coherent with that given ray. For example, the chief rays of each of the first diffraction beams 34, 35, 36 (which correspond to the chief ray of the incident radiation 33) are coherent and could, if combined, interfere at the amplitude level.

This coherence is exploited by the measurement system 30 to determine an aberration map of the projection system PS.

The projection system PS projects part of the first diffraction beams 34, 35, 36 (which is captured by the numerical aperture of the projection system) onto the sensor apparatus 21.

In Figure 4, the sensor apparatus 21 comprises the single second patterning region 32. As described further below (with reference to Figures 5A-5C), second patterned region 32 is arranged to receive these first diffraction beams 34-36 from the projection system PS and to form a plurality of second diffraction beams from each of the first diffraction beams. In order to achieve this, the second patterning region 32 comprises a two-dimensional transmissive diffraction grating. In Figure 4, all radiation that is transmitted by the second patterning region 32 is represented as a single arrow 38. This radiation 38 is received by a detector region 39 of the radiation detector 23 and is used to determine the aberration map.

Each of the first diffraction beams 34-36 that is incident on the patterning region 32 will diffract to from a plurality of second diffraction beams. Since the second patterning region 32 comprises a two-dimensional diffraction grating, from each incident first diffraction beam, a two dimensional array of secondary diffraction beams is produced (the chief rays of these secondary diffraction beams being separated in both the shearing direction (v-direction) and the direction perpendicular thereto (the u-direction). In the following, a diffraction order that is $n^{th}$ order in the shearing direction (the v-direction) and $m^{th}$ order in the non-shearing direction (the u-direction) will be referred to as the $(n, m)^{th}$ diffraction order of the second patterned region 32. In the following, where it is not important what order a second diffraction beam is in the non-shearing direction (the u-direction), the $(n, m)^{th}$ diffraction order of the second patterned region 32 may be referred to simply as the $n^{th}$ order second diffraction beam.

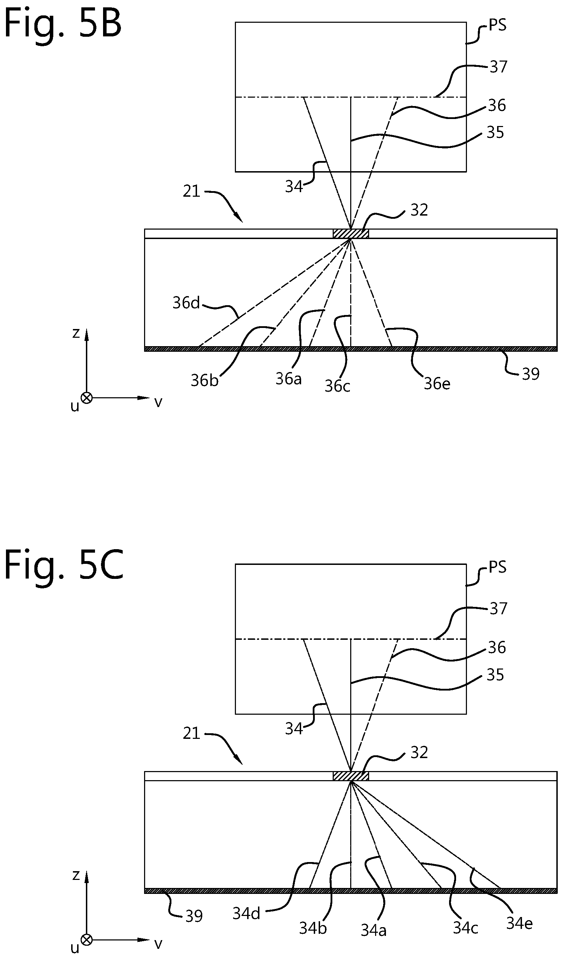

Figures 5A to 5C show a set of second diffraction beams produced by each of the first diffraction beams 34-36. Figure 5A shows a set of second diffraction beams 35a-35e produced by the first diffraction beam 35 that corresponds to the $0^{th}$ order diffraction beam of first patterned region 31. Figure 5B shows a set of second diffraction beams 36a-36e produced by the first diffraction beam 36 that corresponds to the $-1^{st}$ order diffraction beam of first patterned region 31. Figure 5C shows a set of second diffraction beams 34a-34e produced by the first diffraction beam 34 that corresponds to the $+1^{st}$ order diffraction beam of first patterned region 31.

In Figure 5A, second diffraction beam 35a corresponds to the $0^{th}$ order diffraction beam (of second patterned region 32, and in the shearing direction), whereas second diffraction beams 35b, 35c correspond to the $\pm 1^{st}$ order diffraction beams and second diffraction beams 35d, 35e correspond to the $\pm 2^{nd}$ order diffraction beams. It will be appreciated that Figures 5A-5C are shown in the v-z plane and the shown second diffraction beams may, for example, correspond to $0^{th}$ order diffraction beam of second patterned region 32 in the non-shearing direction (i.e. the u-direction). It will be further appreciated that there will be a plurality of copies of these second diffraction beams, representing higher order diffraction beams in the non-shearing direction that are into or out of the page of Figures 5A-5C.

In Figure 5B, second diffraction beam 36a corresponds to the $0^{th}$ order diffraction beam (of second patterned region 32, and in the shearing direction), whereas second diffraction beams 36b, 36c correspond to the $\pm 1^{st}$ order

diffraction beams and second diffraction beams 36d, 36e correspond to the $\pm 2^{nd}$ order diffraction beams.

In Figure 5C, second diffraction beam 34a corresponds to the $0^{th}$ order diffraction beam (of second patterned region 32, and in the shearing direction), whereas second diffraction beams 34b, 34c correspond to the $\pm 1^{st}$ order diffraction beams and second diffraction beams 34d, 34e correspond to the $\pm 2^{nd}$ order diffraction beams.

It can be seen from Figures 5A-5C that several of the second diffraction beams spatially overlap with each other. For example, the second diffraction beam 35b that corresponds to the $-1^{st}$ order diffraction beam of second patterned region 32, which originates from the $0^{th}$ order diffraction beam 35 of first patterned region 31 overlaps with the second diffraction beam 36a that corresponds to the $0^{th}$ order diffraction beam of second patterned region 32, which originates from the $-1^{st}$ order diffraction beam 36 of first patterned region 31. All of the lines in Figures 4 and 5A-5C may be considered to represent a single ray of radiation that originates from a single input ray 33 from the illumination system IL. Therefore, as explained above, these lines represent spatially coherent rays that, if spatially overlapping at radiation detector 23 will produce an interference pattern. Furthermore, the interference is between rays which have passed though different parts of the pupil plane 37 of the projection system PS (which are separated in the shearing direction). Therefore, the interference of radiation that originates from a single input ray 33 is dependent on phase differences between two different parts of the pupil plane.

This spatial overlapping and spatial coherence of the second diffraction beams at radiation detector 23 is achieved by matching the first and second patterned regions 31, 32 such that the angular separation (in the shearing direction) between different second diffraction beams that originate from a given first diffraction beam is the same as the angular separation (in the shearing direction) between different first diffraction beams as they converge on the second patterned region 32. This spatial overlapping and spatial coherence of the second diffraction beams at radiation detector 23 is achieved by matching the pitches of the first and second patterned regions 31, 32 in the shearing direction. It will be appreciated that this matching of the pitches of the first and second patterned regions 31, 32 in the shearing direction takes into account any reduction factor applied by the projection system PS. As used herein, the pitch of a two dimensional diffraction grating in a particular direction is defined as follows.

It will be appreciated that a one-dimensional diffraction grating comprises a series of lines that are formed from a repeating pattern (of reflectivity or transmissivity) in a direction perpendicular to these lines. In the direction perpendicular to the lines, the smallest non-repeating section from which the repeating pattern is formed is referred to as the unit cell and the length of this unit cell is referred to as the pitch of the one-dimensional diffraction grating. In general, such a one-dimensional diffraction grating will have a diffraction pattern such that an incident radiation beam will be diffracted so as to form a one-dimensional array of angularly spaced (but potentially spatially overlapping) diffraction beams. The first patterned region 31 forms such a one-dimensional array of angularly spaced first diffraction beams 34-36, which are offset (angularly spaced) in the shearing direction.

It will be appreciated that a two-dimensional diffraction grating comprises a two-dimensional repeating pattern of reflectivity or transmissivity. The smallest non-repeating section from which this repeating pattern is formed may be referred to as the unit cell. The unit cell may be square and a fundamental pitch of such a two-dimensional diffraction grating may be defined as a length of the square unit cell. In general, such a two dimensional diffraction grating will have a diffraction pattern such that an incident radiation beam will be diffracted so as to form a two dimensional array of, angularly spaced (but potentially spatially overlapping) diffraction beams. The axes of this two-dimensional (square) array of diffraction beams are parallel to the sides of the unit cell. The angular separation between adjacent diffraction beams in these two directions may be given by the ratio of the wavelength of the radiation to the pitch of the grating. Therefore, the smaller the pitch, the larger the angular separation between the adjacent diffraction beams.

In some embodiments, the axes of the unit cell of the two-dimensional second patterned region 32 may be arranged at a non-zero angle to the shearing and non-shearing directions as defined by the first patterned region 31. For example, the axes of the unit cell of the two-dimensional second patterned region 32 may be arranged at 45° to the shearing and non-shearing directions as defined by the first patterned region 31. As previously explained, spatial overlapping and spatial coherence of the second diffraction beams at radiation detector 23 which allows the wavefront to be measured is achieved by ensuring that that the angular separation (in the shearing direction) between different second diffraction beams that originate from a given first diffraction beam is the same as the angular separation (in the shearing direction) between different first diffraction beams as they converge on the second patterned region 32. For an arrangement wherein the axes of the unit cell of the two-dimensional second patterned region 32 are arranged at a non-zero angle (for example 45°) to the shearing and non-shearing directions, it can be useful to define a pseudo-unit cell and a pseudo-pitch as follows. The pseudo-unit cell is defined as the smallest non-repeating square from which the repeating pattern of the diffraction grating is formed, which is orientated such that its sides are parallel to the shearing and non-shearing directions (as defined by the first patterned region 31. The pseudo-pitch may be defined as a length of the square pseudo-unit cell. This may be referred to as the pitch of a two dimensional diffraction grating in the shearing direction. It is this pseudo-pitch which should be matched to (an integer multiple or fraction of) the pitch of the first patterned region 31.

The diffraction pattern of the diffraction grating may be considered to form a two dimensional array of angularly spaced (but potentially spatially overlapping) pseudo-diffraction beams, the axes of this two-dimensional (square) array of pseudo-diffraction beams being parallel to the sides of the pseudo-unit cell. Since this square is not the unit cell (defined as to the smallest square of any orientation from which the repeating pattern of the diffraction grating is formed), the pseudo-pitch will be larger than the pitch (or fundamental pitch). Therefore, there will a smaller separation between adjacent pseudo-diffraction beams in the diffraction pattern (in a direction parallel to the sides of the pseudo-unit cell) than there is between adjacent diffraction beams in the diffraction pattern (in a direction parallel to the sides of the unit cell). This can understood as follows. Some of the pseudo-diffraction beams correspond to diffraction beams in the diffraction pattern and the other pseudo-diffraction beams are unphysical and do not represent a diffraction beam generated by the diffraction grating (and only arise due to the use of a pseudo-unit cell that is larger than the true unit cell).

Taking any reduction (or enlargement) factor applied by the projection system PS into account, either the pitch of the second patterned region 32 in the shearing direction should be an integer multiple of the pitch of the first patterned region 31 in the shearing direction or the pitch of the first patterned region 31 in the shearing direction should be an integer multiple of the pitch of the second patterned region 32 in the shearing direction. In the example shown in Figures 5A-5C, the pitches of the first and second patterned regions 31, 32 in the shearing direction are substantially equal (taking into account any reduction factor).

As can be seen from Figures 5A-5C, each point on the detector region 39 of the radiation detector 23 will, in general, receive several contributions that are summed coherently. For example, the point on the detector region 39 which receives the second diffraction beam 35b that corresponds to the $-1^{st}$ order diffraction beam of second patterned region 32, which originates from the $0^{th}$ order diffraction beam 35 of first patterned region 31 overlaps with both: (a) the second diffraction beam 36a that corresponds to the $0^{th}$ order diffraction beam of second patterned region 32, which originates from the $-1^{st}$ order diffraction beam 36 of first patterned region 31; and (b) the second diffraction beam 34d that corresponds to the $-2^{nd}$ order diffraction beam of second patterned region 32, which originates from the $+1^{st}$ order diffraction beam 34 of first patterned region 31. It will be appreciated that when higher order diffraction beams of the first patterned region 31 are taken into account there will be more beams that should be summed coherently at each point on the detector region 39 in order to determine the intensity of radiation as measured by that part of the detector region 39 (for example a corresponding pixel in a two dimensional array of sensing elements).

In general, a plurality of different second diffraction beams contributes to the radiation received by each part of the detector region 39. The intensity of radiation from such a coherent sum is given by:

$$(2)$$

$$I = DC + \sum_{\text{pairs } \{i\}} \gamma_i \cos(\Delta\phi_i),$$

where $DC$ is a constant term (which is equivalent to the incoherent sum of the different diffraction beams), the sum is over all pairs of different second diffraction beams, $\gamma_i$ is an interference strength for that pair of second diffraction beams and $\Delta\phi_i$ is a phase difference between that pair of second diffraction beams.

The phase difference $\Delta\phi_i$ between a pair of second diffraction beams is dependent on two contributions: (a) a first contribution relates to the different part of the pupil plane 37 of the projection system PS from which they originate; and (b) a second contribution relates to the position within the unit cells of each of the first and second patterned regions 31, 32 from which they originate.

The first of these contributions can be understood to arise from the fact that the different coherent radiation beams have passed through different parts of the projection system PS and are therefore related to the aberrations that it is desired to determine (in fact they are related to a difference between two points in the aberration map that are separated in the shearing direction).

The second of these contributions can be understood to arise from the fact that the relative phases of multiple rays of radiation that arise from a single ray incident on a diffraction grating will depend on which part of the unit cell of that grating the ray was incident. This therefore does not contain information relating to the aberrations. As explained above, in some embodiments, the measurement patterning device MA' and/or the sensor apparatus 21 are sequentially scanned and/or stepped in the shearing direction. This causes the phase differences between all of pairs of interfering radiation beams received by the radiation detector 23 to change. As the measurement patterning device MA' and/or the sensor apparatus 21 are sequentially stepped in the shearing direction by an amount that is equivalent to a fraction of the pitches (in the shearing direction) of the first and second patterned regions 31, 32, in general, the phase differences between pairs of second diffraction beams will all change. If the measurement patterning device MA' and/or the sensor apparatus 21 are stepped in the shearing direction by an amount that is equivalent to an integer multiple of the pitches (in the shearing direction) of the first and second patterned regions 31, 32 the phase differences between pairs of second diffraction beams will remain the same. Therefore, as the measurement patterning device MA' and/or the sensor apparatus 21 are by sequentially scanned and/or stepped in the shearing direction, the intensity received by each part of the radiation detector 23 will oscillate. The first harmonic of this oscillating signal (which may be referred to as a phase-stepping signal), as measured by the radiation detector 23, is dependent on the contributions to equation (1) that arise from adjacent first diffraction beams 34-36, i.e. first diffraction beams that differ in order by $\pm 1$. Contributions that arise from first diffraction beams that differ in order by a different amount will contribute to higher order harmonics of the signal determined by the radiation detector 23 due to such phase stepping techniques.

For example, of the three overlapping second diffraction beams discussed above (35b, 36a and 34d) only two of the three possible pairs of these diffraction beams will contribute to the first harmonic of the phase stepping signal: (a) second diffraction beams 35b and 36a (which originate from the $0^{th}$ order diffraction beam 35 and the $-1^{st}$ order diffraction beam 36 of first patterned region 31 respectively); and (b) second diffraction beams 35a and 34d (which originate from the $0^{th}$ order diffraction beam 35 and the $+1^{st}$ order diffraction beam 34 of first patterned region 31 respectively).

Each pair of second diffraction beams will result in an interference term of the form shown in equation (2), which contributes to the first harmonic of the phase stepping signal, i.e. an interference term of the form:

$$(3)$$

$$\gamma \cos(\frac{2\pi}{p} \cdot v + \Delta W)$$

where y is an amplitude of the interference term, p is the pitch of the first and second patterned regions 31, 32 (in the shearing direction), v parameterizes the relative positions of the first and second patterned regions 31, 32 in the shearing direction and $\Delta W$ is a difference between the value of the aberration map at two positions in the pupil plane of the projection system PS, the two positions corresponding to the positions from which the two second diffraction beams originate. The amplitude y of the interference term is proportional to the product of the compound scattering efficiencies of the two second diffraction beams, as discussed further below. The frequency of the first harmonic of the phase stepping signal is given by the inverse of the pitch p of the first and second patterned regions 31, 32 in the shearing direction. The phase of the phase stepping signal is given by $\Delta W$ (the difference between the values of the aberration map at two positions in the pupil plane of the projection system PS, the two positions corresponding to the positions from which the two second diffraction beams originate).

The interference strength $\gamma_i$ for a pair of second diffraction beams is proportional to the product of the compound scattering efficiencies of the two second diffraction beams, as now discussed.

In general, the scattering efficiency of the diffraction beams produced by a diffraction grating will depend on the geometry of the grating. These diffraction efficiencies, which may be normalised to the efficiency of a $0^{th}$ order diffraction beam, describe the relative intensities of the diffraction beams. As used herein, the compound scattering efficiency of a second diffraction beam is given by the product of the scattering efficiency of the first diffraction beam from which it originates and the scattering efficiency for the diffraction order of the second patterned region 32 to which it corresponds.

In the above description of the embodiments shown in Figures 3A to 5C, where the first portion 15a' of the patterned region 15a shown in Figure 3A is illuminated, the shearing direction corresponds to the v-direction and the non-shearing direction corresponds to the u-direction. It will be appreciated that when the second portion 15a" of the patterned region 15a shown in Figure 3A is illuminated, the shearing direction corresponds to the u-direction and the non-shearing direction corresponds to the v-direction. Although in these above-described embodiments, the u and v-directions (which define the two shearing directions) are both aligned at approximately 45° relative to both the x and y-directions of the lithographic apparatus LA, it will be appreciated that in alternative embodiments the two shearing directions may be arranged at any angle to the x and y-directions of the lithographic apparatus LA (which may correspond to non-scanning and scanning directions of the lithographic apparatus LA). In general, the two shearing directions will be perpendicular to each other. In the following, the two shearing directions will be referred to as the x-direction and the y-direction. However, it will be appreciated that these shearing directions may be arranged at any angle relative to both the x and y-directions of the lithographic apparatus LA.

The description herein above describes a setup and method to determine aberrations in the projection optics using two patterned regions. Herein, the patterned regions 15a-15c may be referred to as first patterned regions or first gratings 15. The plurality of diffraction gratings 19a-19c may be referred to as second patterned regions or second gratings 19 (see Figure 2).

The first and second gratings may comprise any number of patterned regions, such as gratings. In a practical embodiment, the first gratings 15 and the second gratings 19 comprise on the order of 5 to 20 gratings.

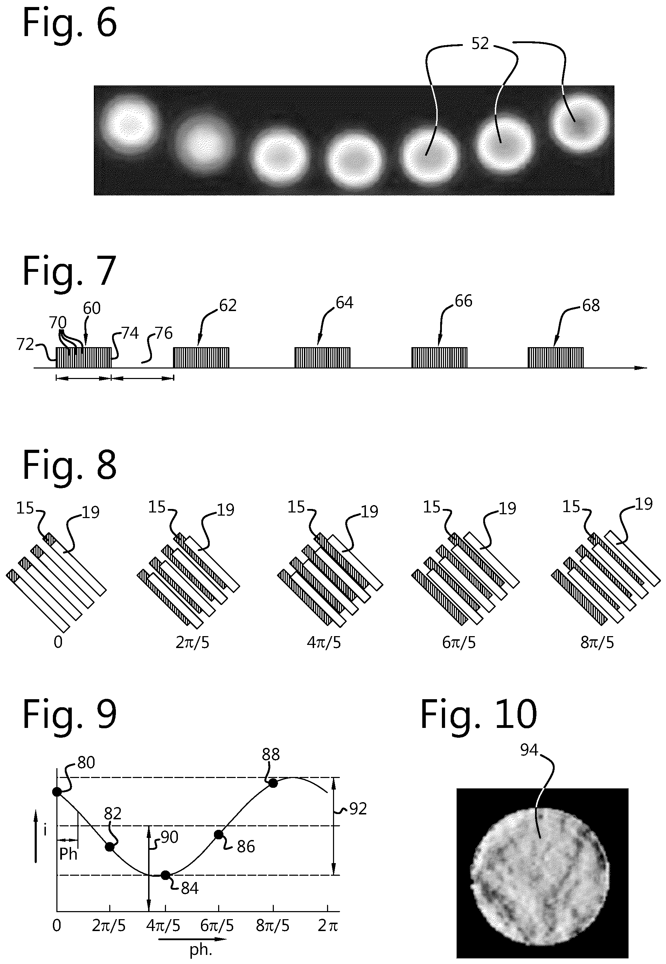

Grating as used herein is a generic term. Herein, a grating may comprise, but is not limited to, a pattern of parallel line structures. A grating pattern may also be two-dimensional, as exemplified in Figure 3B. A grating may have a two-dimensional structure resembling a checkboard. A pinhole shape is also conceivable. The first or second gratings may include an array of gratings, including a combination of respective gratings having a different pattern. Herein, a first grating may include (predominantly) one-dimensional structures, such as an array of lines (see Fig. 8). A second grating of the array may have a two-dimensional structure. A third grating may have a pinhole shape. Herein, respective gratings included in the array may be used for different types of scanners for the aberration measurement according to the present disclosure.

Typically, respective gratings of the first and second gratings are arranged in line. In other words, all gratings comprised in the first gratings and/or the second gratings are arranged in a linear fashion. See for instance, Figures 3A and 3B.

As described in the introduction, state of the art sensor systems may enable to measure aberrations of the projection system using overlap of multiple gratings at the same time. Generally referring to Figure 6, for instance, the width of the detector 23 may enable to measure an overlap of multiple gratings simultaneously. The detector 23 may be able to measure about five to ten, for instance about seven or eight, gratings simultaneously. Figure 6 shows an output 50 showing multiple maps 52 of adjacent gratings.

The width of the detector 23 allowing to measure multiple grating overlaps at the same time allows to obtain sufficient aberration and alignment information within a relatively short time period. It facilitates the aberration control and alignment required for accurate projection, while limiting the time required for the measurement and thus limiting the impact on productivity.

As exemplified in Figure 6, the respective phase maps 52 may be obtained on a curvature, or curved pattern. The latter is due to the fact that, for lithography systems based on EUV, the beam B of radiation as projected towards the substrate W may be curved. The curvature of the beam B may be obtained by including a curved illumination opening CS somewhere in the optical path between the source SO and the substrate W (see Figure 1). The curved opening CS may be referred to as the illumination slit. Said curvature may be required for reasons outside the scope of the present disclosure. Nevertheless, the curvature of the beam B, and the potential curvature of the curved opening CS, does impact the effectiveness of the method as described herein, and the potential to obtain multiple phase maps in parallel, as depicted in Figure 6.

Generally referring to Figures 6 to 10, a conventional measurement method known as "phase stepping interferometry" can be described as follows. As sketched in Figure 8, for interference, an image of the first gratings 15 (typically, a linear arrangement of patterned regions linearly arranged on an edge of the reticle) is projected through the projection optics to the wafer level. The image of the first grating 15 overlaps with second gratings 19 located at the wafer stage WS and results in interference on the detector 23, typically including a camera, arranged below the second gratings 19 (see Fig. 2).

The aberration of the projection optics can be derived from the interferogram. In order to resolve the aberration effectively from the interferogram, a phase stepping technique is introduced as illustrated in Figure 7. As example only, the technique is described using for instance five phase steps 60 to 68.

Figure 7 schematically indicates a firing pattern of radiation pulses 70, originating from the source SO during a scan. Each step of the firing pattern has a start or first pulse 72, and an end or last pulse 74. During each step, the sensor camera (i.e. the detector 23) takes an image. Herein, the detector 23 integrates the radiation received by the detector during the entire step, while the source SO fires the pulses 70, from the first pulse 72 to the last pulse 74.

Between respective steps 60 to 68, for instance the first gratings 15 will be shifted by a portion of the grating pitch with respect to the second gratings 19 to a new position. More accurately, in operation the gratings 15 are displaced such that an image of the first gratings as projected onto the second gratings 19 is shifted over a portion of the grating pitch of the second gratings 19. So, in Figure 8, the 'first gratings 15' in fact represent the image of one grating of the first gratings 15, as observed by, or as projected onto, a corresponding grating of the second gratings 19. See arrow 76 in Figure 7. To be precise, there is no relative movement orthogonal to a grating line. Movement parallel to the grating line is possible for the purpose of improving measurement quality by averaging out the mark imperfection, as described herein above. The relative movement 76 of one grating pattern with respect to the other causes a change in the transmission. During imaging, i.e. during each step 60 to 68, both the first gratings 15 and the second gratings 19 are stationary, i.e. there is no relative movement.

Figure 8 sketches the different overlap between both grating patterns during the five different phase steps 60 to 68. Consequently, the five steps result in five different images. The accumulated signal on each pixel of the camera of the detector 23 varies for every image, according to the overlap between the first gratings 15 and the second gratings 19 as exemplified in Figure 7.

Generally referring to Figure 9, the intensity $i$ versus the phase difference $ph$ between the first gratings 15 and the second gratings 19 (see figure 8) follows a sinusoidal curve 80 defined by the interference. Herein, intensity can be estimated as: *Intensity = offset + modualtion * cos(phase_step + phase_gradient)*.

On each pixel of the camera, one can derive an offset 90, modulation 92 and phase gradient from the intensity signal 80 to 88 corresponding to the five images (Fig. 8) of steps 60 to 68 (Fig. 7).

Corresponding mathematical treatment relating to all pixels of the detector 23 relating to the interference region results in an offset map, a modulation map and a phase gradient map.

Figure 10 provides an example of the phase gradient map 94. The phase gradient map can be further derived into aberration represented by Zernike coefficients, as exemplified herein above.

As outlined in the introduction, the aberration measurement using the phase stepping method has a few disadvantages, for instance:

1. The phase stepping method does first stepping, then sampling with a fixed grating layout. A certain minimum amount of phase steps are required to accurately construct the phase curve. Combined with limitations of the camera readout speed (typically on the order of 100 Hz) and control systems of parts (such as the source, the substrate stage WS, and the reticle stage RS), the measurement time cannot be reduced below a certain threshold, for instance on the order of 100 ms. In other words, further improvement in productivity is difficult to realize, due to timing constraints of the method required for alignment.

2. To speed up production in lithographic systems, such as EUV scanners, it is highly beneficial to use a single sensor system to perform multiple measurement steps. For instance, the same sensor system may be used both for reticle alignment and aberration measurement of the projection system at the same time. The main benefit would be throughput gain by combining two inline correction actions into one single action using the same sensor. Combining two inline corrections into one single action using the same sensor for an EUV based lithographic apparatus can improve the productivity. The latter however is only achievable when the combined measurement does not exceed the time required for two separate measurement. The latter is difficult to achieve, given the curved illumination slit, see the paragraphs herein below. Another limiting factor is that conventionally, aberration measurement and reticle alignment are done using two different sensors. Herein, the alignment sensor is unable to handle the aberration measurement. So, to improve productivity on the order of about 1 to 5% (as expected when using the system or method of the present disclosure), one needs to combine these two actions into the aberration measurement sensor. If in addition one can make sure that the single combined measurement shall not exceed the time required for a conventional single aberration measurement, a productivity gain of at least 5% is deemed possible.

Herein, output gain would improve more for faster aberration measurements. However, the phase stepping method cannot feasibly be made any faster, as outlined above. The faster the aberration measurement can be, the larger the throughput gain can be. An estimation of productivity gain is on the order of 5 extra substrates per hour (or about 1 to 5% increase). The latter can be achieved using two single scans using the method of the present disclosure, one measurement relating to a grating pattern on one edge of the reticle and another measurement relating to another grating pattern on an opposite edge of the reticle.

As outlined herein above, mainly due to economics, the multiple grating patterns included in the first gratings arranged on the reticle are typically arranged in a straight line with respect to each other. Herein, the multiple gratings are typically arranged on an outer edge of the reticle. This enables to maximize the space available on the reticle for a pattern.

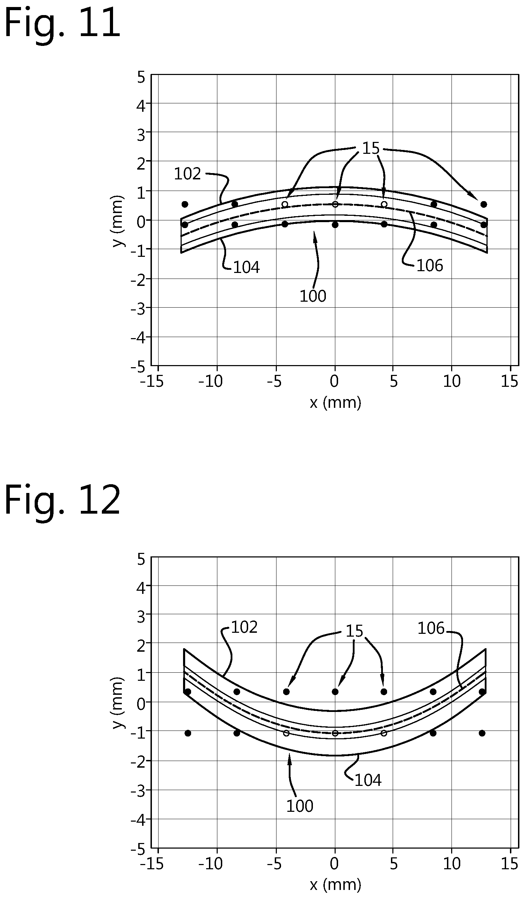

However, as referenced above, the EUV illumination slit CS is curved. The curved illumination opening CS provides a curved projected beam 100 of radiation (Fig. 11, 12). Said curved beam has outer edges 102, 104 and a midline. The radiation intensity is typically maximal at said midline. The curvature of the curved beam 100, wherein curvature herein is a maximum position difference at the substrate W between respective positions along the beam 100, may be on the order of about 10 to 100 mm, for instance about 30 to 80mm.

Generally referring to Figures 11 and 12, due to the curvature of the illumination opening CS and the beam 100, it is typically impossible to cover all grating patterns 15a-15c included in the first gratings 15 at the desired field positions. Ideally, all grating patterns 15a-15c would be covered by sufficient intensity of radiation during a single pulse. Nevertheless, as exemplified in Figures 11 and 12, while some grating patterns may be covered by radiation having sufficient intensity, i.e. at or near the midline 106 of the beam 100, other grating patterns may not receive sufficient radiation to provide sufficient output for creating an interference pattern. As a result, at least two or more measurements may need to be performed to provide interference patterns for all grating patterns 15a-15c. Consequently, the stepping method is unsuitable and unable to provide any further productivity gain and is a limiting factor, potentially even reducing output.

The present disclosure proposes a different way to perform aberration measurement of the projection system PS. A method of the disclosure uses "phase scanning" instead of "phase stepping" to allow measuring all patterned regions fitting within the scope of the detector within one measurement, as illustrated in Figures 11 and 12.

A phase scanning method as disclosed herein may have the following characteristics. A reticle or mask MA is arranged on the reticle or mask stage MT (Fig. 1). Herein, the reticle is provided with first gratings 15. The first gratings are typically arranged in linear fashion. For instance, the first gratings 15 are arranged on a line. The second gratings 19 are included in a sensor system 21 (Fig. 2). The second gratings 19 are typically arranged in linear fashion. For instance, the second gratings 19 are arranged on a line.

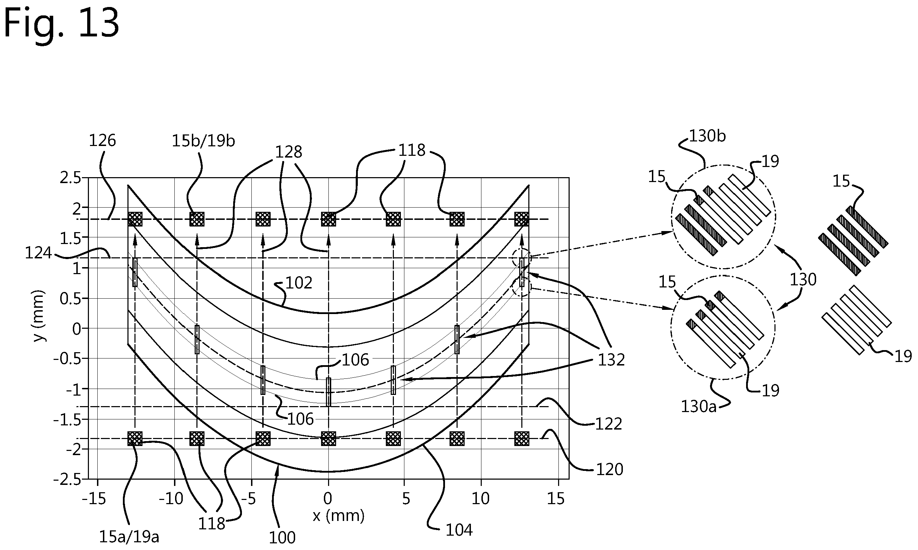

Figure 13 exemplifies a method in accordance with the present disclosure. Figure 13 schematically shows overlapping projections 118 of respective first gratings 15 (reflections) and second grating 19 (transmission) on the camera or detector 23 of the sensor 21. First line 120, second line 122, third line 124, and fourth line 126 represent different relative positions of the projections of the first gratings 15 with respect to the second gratings 19. Arrows 128 represent a direction of relative movement of the first gratings 15 with respect to the second gratings 19. As described herein above, either the first gratings move with respect to the second gratings, the second gratings move with respect to the first gratings.

Preferably, both the first gratings 15 and the second gratings 19 are moved at a constant yet slightly different speed, creating a constant relative movement. Said relative movement is in the direction of the arrows 128, i.e. is substantially perpendicular to the linear arrangement of the respective first and second gratings.

During a method of the disclosure, the respective gratings 15, 19 are illuminated with a curved beam of radiation 100 originating from the illumination slit CS. Said beam has a forward edge 102, and aft edge 104, and a midline section 106. At the midline section 106, the radiation has the highest intensity. At the midline section 106 (shown as a curved section in Fig. 13), the radiation is sufficiently homogeneous for aberration measurement of the projection system PS.

During a method of the present disclosure, the detector or camera 23 of the sensor takes images 130 of the projections of the overlapping first and second gratings. The detector may typically take images constantly, at a predetermined sample rate.

The first line 120 exemplifies a starting position. At the starting position, the reticle stage MT and the substrate table WT start to move. At the starting position 120, the detector may start taking images. Said images are prior to the measurement. At the starting position, all overlapping grating projections 118 are located outside of the mid-section 106. There is no overlap between respective grating projections and the detector does not detect interference.

The fourth line 126 exemplifies an end position. At the end position, the reticle stage MT and the substrate table WT stop moving.

The second line 122 and the third line 124 represent a start of the sampling position and an end of the sampling position respectively. The start sampling position and stop sampling position are represented by line 122 and line 124 respectively. The camera of the detector takes images when between the positions represented by line 122 and line 124, at least. The camera can start taking images at line 120, but the images taken before reaching line 122 and after leaving line 124 may not have good quality information. In a practical embodiment, said images are disregarded to the aberration measurement as outlined below. In an embodiment, only images obtained between the start sampling position and stop sampling position are used for the measurement,

At the stop sampling position represented by third line 124, the overlapping grating projections 118 are at the end of the measurement. At the end position, the detector is instructed to stop taking images. All overlapping grating projections 118 are located outside of the mid-section 106. There is no overlap between respective grating projections and the detector does not detect interference.

During the measurement in accordance with the method of the disclosure, the reflection of the first gratings moves at constant relative speed with respect to the second gratings in the direction of arrows 128. The vertical axis in Fig. 13 represents a changing relative position y (for instance in mm) of the reflection of the first gratings with respect to the transmission of the second gratings as projected onto the detector. Referring to Fig. 13, one may consider that the row of overlapping grating projections 118 moves upwards in time. During said movement, the overlap of respective gratings 15a-19a, 15b-19b, 15c, 19c, etc., each move through the mid-section 106 of the radiation of the illumination slit at different times and at different positions. The line sections 132 represent when images 130 for a particular grating combination move through the mid-section 106. Herein, a first image 130a may represent a start of the measurement. A second image 130b may represent an end position of the measurement. When a pair of gratings 15a/19a moves through the mid-section 106 of the radiation, images for measurement are taken while said pair moves through the respective line section 132 corresponding to said pair.

In a practical embodiment, the method of measurement includes movement on both the substrate table WT and the reticle stage MT from a first position, also referred to as a "start scanning position", to a second position, also referred to as a "stop scanning position". Herein, both the reticle stage and the substrate stage may move at the same time.

The reticle stage MT may move at a reticle stage speed. In a practical embodiment, said reticle stage speed provides the reflection of the first gratings 15 on the second gratings a first speed. Said first speed may be substantially constant. The substrate table WT may move at a second speed. The second speed may differ from the first speed, to allow a relative movement of the reflection of the first gratings 15 with respect to the second gratings 19. The latter provides subsequent images as received by the detector wherein the patterns provided by the respective first and second gratings on the detector 23 move with respect to each other. See Fig. 13.

The difference between the first speed and the second speed can be selected in correspondence with an imaging speed or sampling rate of the detector 23. Thus, the relative speed can be selected to allow ample time for the detector to capture a sufficient number of interference patterns to determine the phase curves (as described herein above). Herein, the first speed, the second speed, and the relative speed are typically directed in a direction of movement substantially perpendicular to the linear arrangement of the respective first and second gratings. See the arrows 128 in Fig. 13.

In a practical embodiment, the projection system provides a (de)magnification with respect to the reflection of the first gratings. Thus, in a practical embodiment, the wafer stage (provided with the second gratings) is moving at a relative speed with respect to the changing reflection of the first gratings as projected onto the second gratings. The reflected image of the first gratings arrives on the wafer stage at a fixed position. The latter assumes that the optical elements in the projection system are not displaced. The pattern in the reflection of the first gratings changes due to the movement of the reticle stage. Said reticle stage moves at the reticle stage speed, which determined the first speed. This movement of the pattern in the image can for instance by about four to eight times slower than the movement of the reticle stage (moving at the reticle stage speed. The second gratings are provided with a relative speed with respect to movement of said pattern.

In an embodiment, the "start scanning" and "stop scanning" positions are located at a certain distance away from the plateau area 106 of the illumination slit CS. In other words, at the start of the measurement, the plateau section 106 of the radiation beam 100, which has the maximum intensity, does not yet provide an overlap of the images of the first gratings 15 and the second gratings 19 on the detector 23. Said distance allows both the reticle table MT and the substrate table WT to accelerate to a steady speed, before the first overlapping pair reaches the plateau section 106. The latter is indicated by the second line 122 in Fig. 13.

At the start position, at the first line 120, the substrate table WT and the reticle stage MT may typically start to move, aiming to reach a constant speed.

Between the start sampling position, at the second line 122, and the stop sampling position, at the third line 124, the substrate table WT and the reticle stage MT typically move at a constant speed, and thus at a constant relative speed. At the same time, the source SO fires radiation pulses, such as EUV pulses. The radiation pulses are fired continuously. The camera or detector 23 takes images 130 of the radiation 17 transmitted through the second gratings 19.

The reticle stage MT and the substrate stage WT may decelerate and stop after the last grating pair 118 leaves the radiation plateau 106. The latter is exemplified by the third line 124 in Fig. 13.

In an embodiment, the images are obtained with the detector set in high frequency flash mode. The detector may capture the images 130 continuously.

During at least part of the measurement, the reflection of the first gratings 15 and the transmissive pattern of the second gratings 19 as captured by the sensor detector 23 overlap. The relative phase of the first gratings 15 and the second gratings 19 (which is comparable to the stepping phase in the phase stepping method as described above) is obtained by the speed difference between the first speed (of the reticle stage MT) and the substrate table WT. Said speed difference causes a mismatch between the two gratings.

The first speed and the second speed may be selected such that the relative movement of the reflection of the first gratings 15 of the reticle stage MT with respect to the second gratings 19 of the substrate stage WT during the complete sampling phase, see the line sections 132 in Fig. 13, exceeds multiple periods of the respective gratings. An example is shown in Figure 13, wherein both gratings overlap in the first image 130a and are mismatched by two grating periods in the second image 130b. The scanning phase at least allows to capture a sufficient number of images 130 of overlap of respective grating pairs 15a-19a, 15b, 19b, etc. to derive the phase curve, as exemplified herein below.

For each grating pair, the moment of the first image 130a (when entering the plateau section 106) and the second image 130b (when leaving the plateau section 106) will typically occur at a different moment. The region 132 between the first image 130a and the second image 130b can be designed to be sufficient for the measurement. The first image 130a may indicate the image when sampling for a specific grating pair 118 starts, and the second image 130b indicates the image when sampling for the respective pair 118 stops.

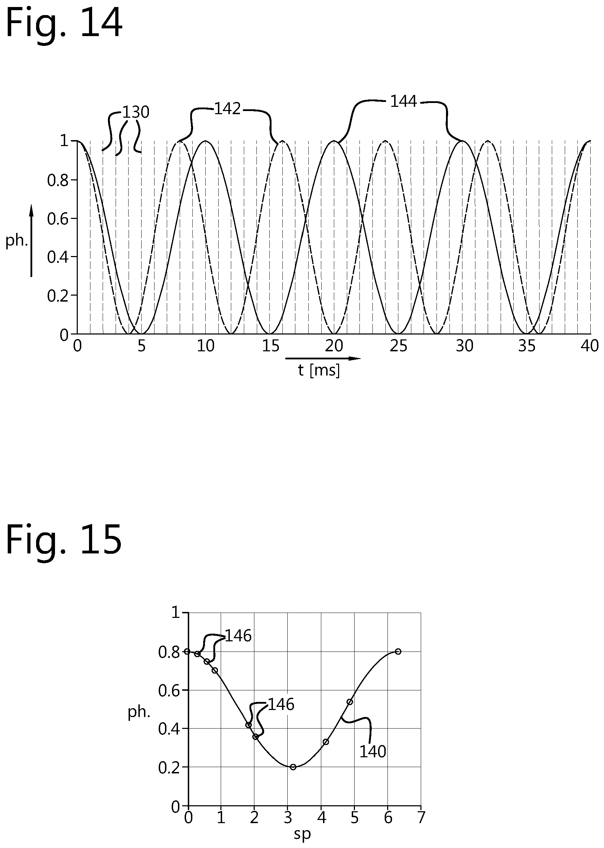

Generally referring to Figures 14 and 15, a phase curve 140 can be retrieved from the image samples 130. Figure 14 shows a simplified example to demonstrate the concept of the present disclosure. For instance, the grating pitch between respective lines of respective patterns included in the first and second gratings may be, for instance, on the order of 10 nm. The first speed of the reticle stage may be about 0.5 to 2 $\mu$m per second, for instance about 0.8 $\mu$m per second. The second speed of the substrate table may be on the order of 0.6 to 3 $\mu$m per second, for instance about 1 um per second. The detector 23 may include a camera able to obtain images 130 at a sample rate of about 0.3 to 2 kHz, for instance at about 1 kHz.

Figure 14 shows the phase ph on the vertical axis versus time t [ms] on the horizontal axis. Herein, for instance, when moving at constant first speed and second speed respectively, first line 142 indicates the phase of the first gratings with respect to a starting position or reference. Second line 144 indicates the phase of the second gratings with respect to a starting position or reference. Due to the relative movement of the reticle stage with respect to the substrate stage, after a predetermined time period, for instance of about 40 ms, the first gratings will shift with respect to the second gratings by one grating period. During said time period, the detector has obtained a number of images 130, for instance about 40 samples. Said images 130 are distributed along the phase curve based on the relative shift of the first gratings with respect to the second gratings. I.e., the relative phase between the two gratings.

The phase curve 140 can then be constructed similarly to the phase stepping method as described in detail herein above. In Figure 15, the vertical axis indicates phase *ph,* whereas the horizontal axis indicates a scanning phase [in radian]. The phase curve 140 is a fit to measurements 146 of the relative phase, derived from respective images 130 during the measurement 132 for a respective grating pair.

A significant difference between the method of the present disclosure and conventional methods is the direction of the scanning move with respect to the grating lines. The direction of relative movement substantially perpendicular to the grating lines leads to a relative phase difference induced during the scanning move. This phase difference is equivalent to the alignment of the gratings, which is required for the aberration measurement.

In conventional methods, the scanning move is parallel to the grating line direction. Because it is orthogonal to the diffraction direction of the grating, such scanning move will not cause any phase difference. It only averages out intensity variation that may occur due to manufacturing imperfections.

The scanning move in the method of the present disclosure includes a component which is other than parallel to the grating line direction. In this way, a relative phase difference can be induced during the scanning move. Said phase difference enables the aberration measurement in accordance with the method of the disclosure.

The method and system of the present disclosure provide a number of significant benefits. For instance, as the substrate stage and the reticle stage move during the measurement, the conditions during the measurement resemble the conditions during exposure. The latter may include potential vibrations or other mechanical influences due to stage movements. As a consequence, the measurement result will be closer to an exposure scenario, rendering the overall result more accurate compared to a stationary measurement. Secondly, the method and system of the disclosure can be used in combination with all possible curvatures of the illumination slit. The latter include quite extreme scenarios, wherein the curvature of the illumination slit is quite extreme. Thus, the method and system of the disclosure are relatively flexible, and can be used in combination with a wide range of lithographic systems without have to be fine-tuned with respect to a particular system.

The method of the present disclosure can be applied to a lithographic scanner, or another exposure apparatus. Details and specifics of all components and features of the method can be selected depending on specifics of the respective lithographic apparatus or exposure apparatus. For instance, the first speed and the second speed of the reticle stage MT and the substrate table WT respectively may be selected depending on the lithographic scanner, the standard moving speed of the respective reticle stage and substrate stage, the pitch of the respective grating patterns, the size of the grating patterns, and the maximum readout speed of the detector 23. The features may be selected to ensure the number of images exceeds a threshold allowing sufficient samples to construct the phase curve 140. Herein, the features and speeds may be selected to limit the measurement time. In a practical embodiment, the method and system enable to construct the phase curve 140 at least within a time period that is comparable to, or shorter than, the measurement time of one single scan using the phase stepping method as described above.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1.    A method for determining aberrations of a projection system of a lithographic apparatus, the method comprising the steps of:

   providing multiple first gratings (15) arranged on a reticle (MA);
   providing multiple second gratings (19) arranged at or near a substrate table (WT),
   projecting a beam (B) of radiation from a source (SO) towards the first gratings (15) through an illumination slit (CS) and to the substrate table via projection optics of the projection system (PS);
receiving reflected radiation from the first gratings by the second gratings (19) while moving the second gratings relative to the reflected radiation of the first gratings,
capturing radiation received through the second gratings to provide images, and
using the images to determine aberrations of the projection optics.

2. The method of claim 1, comprising the steps of:

   determining phase curves for each pixel of the respective images, and
   using the phase curves for determining the aberrations of the projection optics.

3. The method of claim 1 or 2, wherein the step of capturing radiation received through the second gratings includes using a camera sensor in a high frequency flash mode.

4. The method of one of claims 1 to 3, wherein moving the second gratings relative to the reflection of the first gratings comprising moving the reflection of the first gratings at a first speed, and moving the second gratings at a second speed.

5. The method of claim 4, wherein the first speed and the second speed are substantially constant.

6. The method of claim 4 or 5, wherein the first speed differs from the second speed.

7. The method of one of claim 4 to 6, wherein the first speed and the second speed in combination provide a substantially constant relative speed of the second gratings relative to the reflection of the first gratings.

8. The method of one of the previous claims, wherein the step of capturing radiation includes capturing images covering at least two periods of a mismatch between the reflection of the first gratings and the second gratings.

9. The method of one of the previous claims, wherein the images are captured at a sample rate allowing at least two or more images per grating period of the second gratings.

10. The method of one of the previous claims, wherein the illumination slit (CS) is curved, and wherein the multiple first gratings (15) and the multiple second gratings (19) are arranged linearly.

11. The method of claim 10, wherein the first speed and the second speed have a direction of movement which is substantially perpendicular to the linear arrangement of the first gratings (15) and the second gratings (19).

12. A system for determining aberrations of projection optics of a lithographic apparatus, the system comprising:

    multiple first gratings (15) arranged on a reticle (MA);
    multiple second gratings (19) arranged at or near a substrate table (WT),
    a source (SO) for projecting a beam (B) of radiation towards the substrate table through an illumination slit (CS) and via projection optics of a projection system (PS); and
    a detector (23) for capturing radiation received through the second gratings (19) to provide images,
    the detector (23) being adapted to:

       receive reflected radiation from the first gratings and transmitted through the second gratings,
       make images while moving the second gratings relative to the first gratings, and
       use the images for determining aberrations of the projection optics.

13. The system of claim 10, wherein the detector (23) includes a camera sensor able to operate in a high frequency flash mode.

14. The system of claim 12 or 13, wherein the illumination slit (CS) is curved providing a curbed beam (B), and wherein the multiple first gratings and the multiple second gratings are arranged linearly.

15. The system of claim 14, wherein the system is adapted to move a reflection of the first gratings at a first speed and the second gratings at a second speed in a direction of relative movement which is substantially perpendicular to the linear

EP 4 579 340 A2

arrangement of the first gratings (15) and the second gratings (19).

16. A lithographic apparatus comprising the system of one of claims 12 to 15.

# Fig. 1

# Fig. 2

# Fig. 3A

MA'

15a  15b  15c

15a'  15a''  15b'  15b''  15c'  15c''

y

z  x

v  u

# Fig. 3B

21

19a  19b  19c

y

z  x

# Fig. 4

# Fig. 5A

# Fig. 5B

# Fig. 5C

# Fig. 6

# Fig. 7

# Fig. 8

# Fig. 9

# Fig. 10

## Fig. 11

## Fig. 12

Fig. 13

## Fig. 14

## Fig. 15

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2022248154 A1